# EUROPÄISCHE PATENTANMELDUNG

(11) **EP 2 219 426 A1**
(43) Veröffentlichungstag der Anmeldung: **18.08.2010**
(21) Anmeldenummer: 09151869.6
(22) Anmeldetag: 02.02.2009
(51) Int. Cl.: H05K 3/24, H05K 3/34

(54) **Verfahren zum Herstellen von Kontaktstellen**

(71) Anmelder: Beckhoff Automation GmbH, 33415 Verl (DE)
(72) Erfinder: Schlegel, Michael, 32657 Lemgo (DE); Schmidt, Dietmar, 33739, Bielefeld (DE); Büsselmann, Jan-Dierk, 26209 Hatten Streekermoor (DE)
(74) Vertreter: Patentanwaltskanzlei WILHELM & BECK

(57) **Zusammenfassung**

Die Erfindung betrifft ein Verfahren zum Herstellen von Kontaktstellen (10) aus einer Leitpaste (2) auf einem Träger (1), insbesondere einer Leiterkarte, wobei die Leitpaste (2) ein Flussmittel und zumindest einen leitenden Werkstoff aufweist, der als Körner (11) in der Leitpaste (2) enthalten ist, mit den folgenden Schritten: Anbringen einer Schablone (3) mit Öffnungen (6,14), die die Kontaktstellen auf dem Träger (1) festlegen, Einbringen der Leitpaste (2) in die Öffnungen (6,14) der Schablone (3), wobei mithilfe eines Rakels (9) die Leitpaste (2) auf der Schablone (3) verteilt und in die Öffnungen (6,14) gedrückt wird und Aufschmelzen der Leitpaste (2), wobei eine verschmolzene Schicht auf dem Träger (1) ausgebildet wird. Die Leitpaste weist Körner auf, deren Durchmesser überwiegend, insbesondere wenigstens zu 80 Prozent, im Bereich von 15 bis 40 Mikrometer liegt, und die Schablone weist im Bereich der Öffnungen (6,14) eine Dicke bis zu 50 Mikrometer auf.

## Beschreibung

Die Erfindung betrifft ein Verfahren zum Herstellen von Kontaktstellen aus einer Leitpaste auf einem Träger, insbesondere einer Leiterkarte, wobei die Leitpaste ein Flussmittel und zumindest einen leitenden Werkstoff aufweist, der als Körner in der Leitpaste enthalten ist.

Durch die EU-Richtlinie 2002/95/EG wurde die Verwendung gefährlicher Substanzen zur Herstellung und Verarbeitung von elektrischen und elektronischen Geräten und Bauteilen eingeschränkt. Insbesondere soll in Zukunft auf den Einsatz von Blei in zinnhaltigen Kontaktstellen und Bauteilen verzichtet werden. Die üblicherweise eingesetzten bleihaltigen Lote bei Kontaktstellen weisen hierbei eine Legierung im Wesentlichen aus Zinn und Blei auf, wobei der Bleianteil vor allem die Schmelztemperatur reduziert und die Flusseigenschaften des Lotes verbessert. Die bleifreien Lote weisen überwiegend Zinn und weitere Zusatzstoffe z.B. Silber und/oder Kupfer zum Ersatz des Bleianteils auf. Durch die erforderliche Umstellung auf bleifreie Lote sind einige Herstellungsverfahren nur noch bedingt oder nicht mehr geeignet, um zinnhaltige Kontaktstellen zu erstellen. Im Gegensatz zu bleihaltigen Loten weisen die bleifreien Lote einen höheren Schmelzpunkt und eine höhere Oberflächenspannung auf. Daraus resultierend, erfordern bleifreie Kontaktstellen eine genauere Prozessüberwachung, da die höheren Prozesstemperaturen nahe an den möglichen Maximaltemperaturen der elektronischen Komponenten liegen.

Werden die zinnhaltigen Kontaktstellen auf einer Leiterkarte als Steckkontakte für eine Kontaktierung mit einem Federelement verwendet, so sind von Kontaktstellen zusätzliche Randbedingungen zu erfüllen. Werden die Kontaktstellen in eine Buchse eingeführt um eine Steckverbindung zu erstellen, so gibt die Buchse ein Toleranzfenster für die Steckverbindung vor, um sowohl eine Führung der Leiterkarte innerhalb der Buchse zu gewährleisten, aber auch um ein Überdehnen der in der Buchse angeordneten Federelemente zu vermeiden. Üblicherweise weisen Buchsen für Leiterkarten der Dicke von 1,1 mm ein Toleranzfenster von ±0,1 mm auf. Innerhalb diese Toleranzfensters ist sowohl der Toleranzbereich der Leiterkarte als auch die Schichtdicke der Kontaktstelle enthalten, sodass eine möglichst dünne, aber eine Dicke von wenigstens 3 µm umfassende Kontaktstelle bereitzustellen ist.

Zum Herstellen von zinnhaltigen Kontaktstellen werden herkömmlicherweise das Chemisch Zinn-Verfahren, das Galvanisch Zinn-Verfahren, das Hot-Air-Leveling-Verfahren (HAL) und das Schablonendruckverfahren eingesetzt. Mit dem Chemisch Zinn-Verfahren ist maximal eine Schichtdicke von ca. 2,5 µm herstellbar. Die Schichtdicke reduziert sich nach weiteren Aufschmelzschritten auf ca. 1 µm. Gewünscht sind jedoch Dicken im Bereich von wenigstens 3 µm um eine sicheren und zuverlässigen Steckkontakt der Leiterkarte zu gewährleisten. Des Weiteren weist das Chemisch Zinn-Verfahren in Verbindung mit Kupfer nur eine bedingte Lagerfähigkeit auf, da das aufgebrachte Zinn im Laufe der Zeit in das Kupfer eindiffundiert. Das Einbringen einer Schicht zwischen Zinn und Kupfer verlangsamt den Diffusionsvorgang, kann ihn aber nicht stoppen.

Bei dem galvanisch Zinn-Verfahren wird galvanisch Zinn auf die Leiterbahn zum Herstellen von Kontaktstellen aufgebracht. Allerdings sind die Herstellungsschritte aufwendig und teuer, sodass gegenwärtig weltweit nur zwei Hersteller dieses Herstellungsverfahren zur Großserienfertigung einsetzen. Das galvanisch Zinn-Verfahren eignet sich ferner nicht für das Wiederaufschmelzen der Kontaktstellen z.B. in einem weiteren Lötprozess, da sich dabei die amorph vorliegenden Atome in der Kontaktstelle neu orientieren und sich tropfenförmig im Bereich der Kontaktstellen anlagern. Dies tritt v.a. bei Schichtdicken von wenigstens 5 µm auf. Durch das Eindiffundieren von Zinn in das Kupfer der Leiterbahnen, reduziert sich die Schichtdicke innerhalb weiterer Lötprozesse, so dass eine zuverlässige Schichtdicke von wenigstens 3 µm an den Kontaktstellen nicht zuverlässig gewährleistbar ist.

Im Hot-Air-Leveling-Verfahren (HAL) werden die Kontaktstellen mit Lot in einem Lotbad versehen und anschließend mit Heißluft abgeblasen. Durch das Eintauchen in das Lotbad wird der Träger thermisch hoch belastet. Dies kann zu thermischen Brüchen und Rissen in der Struktur des Trägers führen. Des Weiteren schwankt die Oberflächenqualität durch die Verwendung von bleifreien Loten, sodass Schichtdicken von wenigstens 3 µm in einer Großserienproduktion nicht sicher einhaltbar sind. Dieses Herstellungsverfahren eignet sich besser für die Verwendung von bleihaltigen Loten als für bleifreie Lote.

Zusammenfassend ist festzustellen, dass die derzeit verfügbaren Herstellungsverfahren für zinnhaltige Kontaktstellen nur bedingt oder nicht geeignet sind, um einfach und kostengünstig Schichtdicken von wenigstens 3 µm herzustellen, die mehrmalig aufschmelzbar sind.

Es ist daher Aufgabe der Erfindung ein Verfahren zum Herstellen von Kontaktstellen, insbesondere mit Schichtdicken von wenigstens 3 µm auf einem Träger, insbesondere einer Leiterkarte, und einen solchen Träger zur Verfügung zu stellen, welche einfach und zuverlässig auch in Großserie umsetzbar sind.

Diese Aufgabe wird durch ein Herstellungsverfahren gemäß Anspruch 1 und einen Träger gemäß Anspruch 12 gelöst. Bevorzugte Ausführungsformen sind in den abhängigen Ansprüchen angegeben.

Gemäß der Erfindung wird eine Leitpaste mit einem Flussmittel und einem leitenden Werkstoff, der als Körner in der Leitpaste enthalten ist, auf einem Träger, insbesondere einer Leiterkarte, aufgebracht, um Kontaktstellen zu erstellen. In einem ersten Schritt wird eine Schablone mit Öffnungen, die die Kontaktstellen markieren, auf dem Träger aufgebracht. Dann wird die Leitpaste auf die Schablone aufgetragen und mithilfe eines Rakels verteilt und in die Öffnungen der Schablone gedrückt. Dabei ist das Verhältnis der Dicke der Schablone an den Öffnungen zu dem durchschnittlichen maximalen Durchmesser der Körner der Leitpaste nicht größer als 1,5, wobei die Schablone im Bereich der Öffnungen nicht dicker als 50 µm ist. Nach dem Aufbringen der Leitpaste wird die Schablone von dem Träger abgenommen und der Träger mit der Leitpaste erhitzt, um die Leitpaste aufzuschmelzen. Hierbei bildet sich eine verschmolzene Schicht auf dem Träger aus, die als Kontaktstelle dient.

Dies hat den Vorteil, dass eine lothaltige Schicht als Kontaktstelle auf den Träger hergestellt werden kann, welche beim wiederholten Erhitzen des Trägers über die Schmelztemperatur des Lotes der Kontaktstelle keine Tropfen auf dem Träger ausbildet und zusammen mit der Leiterkarte innerhalb des für die Buchse vorgegebenen Toleranzfensters liegt. Des Weiteren ist das Verfahren einfach und für eine Großserienproduktion geeignet, da es z.B. in einen Inline-Herstellungsprozess integrierbar ist.

In einer Ausführungsform der Erfindung ist die Dicke der Schablone im Bereich der Öffnungen etwa gleich zum durchschnittlichen maximalen Durchmesser der Körner der Leitpaste. Auf diese Weise wird sichergestellt, dass im Schablonendruckverfahren, wenn ein Rakel die Leitpaste auf der Schablone verteilt und in die Öffnungen der Schablonen die Leitpaste drückt, größere Körner der Leitpaste nicht am Rakel hängen bleiben. Dadurch wird sichergestellt, dass im weiteren Bewegungsablauf des Rakels die Öffnungen und damit die Kontaktstellen nicht frei geräumt werden.

In einer weiteren Ausführungsform der Erfindung wird das Aufschmelzen der Körner der Leitpaste auf dem Träger entweder mithilfe eines Vollkonvektions-Reflow-Lötprozesses, einem Kondensations-Lötprozesses oder eines Infrarot-Lötprozesses durchgeführt. Auf diese Weise kann der Träger auf einem Transportband kontinuierlich durch einzelne Wärmezonen in einem Ofen transportiert werden, wobei in den verschiedenen Wärmezonen die einzelnen Schritte des Lötprozesses durchlaufen werden. Die oben genannten Lötprozesse eignen sich daher insbesondere für eine Inline-Herstellung von Kontaktstellen auf Trägern. Des Weiteren kann das Aufschmelzen gezielt an die Leitpaste und deren Flussverhalten angepasst werden, sodass die Oberflächengüte gezielt gesteuert werden kann.

In einer weiteren Ausführungsform der Erfindung weist der Träger eine Isolierung und Leiterbahnen auf, wobei die Leiterbahnen des Trägers zumindest Nickel und/oder Gold aufweist. Auf diese Weise wird sichergestellt, dass die Leiterbahnen sowohl in aggressiver Umgebung nicht korrodieren aber auch dass die Lagerfähigkeit des Trägers erhöht wird. Da Leiterbahnen aus Kupfer auf Grund der fortschreitenden Oxidation nur für kurze Zeit lötfähig sind, wird auf die Leiterbahnen aus Kupfer eine Nickelschicht aufgebracht, die als Bindeglied zwischen dem Kupfer und der zinnhaltigen Kontaktierung dient. Ferner wird die Nickelschicht, die sich nach kurzer Zeit deaktiviert und damit keine Verbindung mit der zinnhaltigen Kontaktierung eingeht, durch eine Goldschicht geschützt. Die Goldschicht geht beim Aufbringen der zinnhaltigen Kontaktierung in der Zinnschicht in Lösung, sodass das Zinn an der Nickelschicht anbindet.

In einer weiteren Ausführungsform der Erfindung wirkt eine Kraft von bis zu 80 N auf das Rakel und das Rakel bewegt sich gegenüber der Schablone mit einer Geschwindigkeit von 20 bis 40 mm/s entlang der Schablonenoberfläche. Auf diese Weise wird gewährleistet, dass auch bei einem Verhältnis von 1,5 der Dicke der Schablone im Bereich der Öffnungen zu dem durchschnittlichen maximalen Durchmesser der Körner der Leitpaste die Körner, die größer sind als die Dicke der Schablonen im Bereich der Öffnungen nicht am Rakel hängen bleiben, sondern durch eine elastische Verformung des Rakels und des Trägers unter dem Rakel in der Öffnung hindurch gleiten. Dies hat zur Folge, dass Körner, die größer sind als die Dicke der Schablonen im Bereich der Öffnungen, nicht beim Auftragsschritt die Öffnungen in der Bewegung des Rakels wieder frei räumen.

In einer weiteren Ausführungsform der Erfindung umfasst der leitende Werkstoff der Leitpaste insbesondere Zinn, Silber und/oder Kupfer. Auf diese Weise kann auf eine umweltschädliche bleihaltige Leitpaste verzichtet werden.

In einer weiteren Ausführungsform der Erfindung ist die Leitpaste zumindest teilweise auf wasserlöslicher Basis hergestellt. Dies hat den Vorteil, dass die Träger nach dem Aufschmelzschritt umweltfreundlich in einem Reinigungsschritt gereinigt werden können, wobei hierbei auf zusätzliche Reinigungsmittel z. B. Laugen verzichtet werden kann.

In einer weiteren Ausführungsform der Erfindung wird der Träger nach dem Aufschmelzen nass gereinigt. Auf diese Weise wird sichergestellt, dass verkrustete Schichten des Flussmittels oder korrosive Rückstände z. B. Säurerückstände entfernt werden und so ein sicherer und langzeitstabiler Kontakt an den Kontaktstellen zur Verfügung gestellt wird.

In einer weiteren Ausführungsform der Erfindung ist die Schablone in einem Rahmen angeordnet, wobei die Schablone plattenförmig ausgebildet ist und Öffnungen aufweist. Dies hat den Vorteil, dass ein Reißen der Schablone, welche eine geringe Dicke aufweist, durch den Einbau in einen festen Rahmen gegenüber den üblicherweise verwendeten Wechselrahmen vermieden wird. wird.

In einer weiteren Ausführungsform der Erfindung wird die Kontaktstelle des Trägers mittels eines Federelements zum Anschluss an eine Baugruppe kontaktiert. Dies hat den Vorteil, dass die Kontaktstellen mit so genannten "Clean-Pasten" auf dem Träger verlötet werden können. Die "Clean-Pasten" sind nach dem Lötprozess vom Träger zu entfernen, um einer Korrosion des Trägers durch die "Clean-Pasten" vorzubeugen. Dazu wird der Träger nach dem Lötprozess einem Reinigungsschritt unterzogen. Da der Träger noch nicht mit weiteren Bauteilen z.B. SMD-Bauteilen bestückt ist, kann die Reinigungsanlage einfacher aufgebaut sein. Insbesondere kann die Trocknungsstufe schwächer ausgebildet sein, da keine Zwischenräume zwischen den weiteren Bauteilen und dem Träger aufzutrocknen sind. Dies hat den Vorteil, dass die weiteren Bauteile mit so genannten "No-Clean-Pasten" nach dem Reinigungsschritt auf dem Träger verlötet werden können, ohne die Rückstände der "No-Clean-Pasten" entfernen zu müssen. Die "No-Clean-Pasten" weisen nach dem Lötprozess keine korrosiven Eigenschaften und können auf dem Träger verbleiben. Sie bilden jedoch einen krustenartigen Belag auf der Lötstelle aus, der mittels Lösungsmittel zu entfernen ist sofern die Lötstelle als Kontaktstelle dient und mittels eines Federelements kontaktiert wird. Ferner kann der Träger durch die Herstellung wenigstens einer Kontaktstelle mittels eines Federelements mit einer weiteren Baugruppe kontaktiert werden, ohne dass hierfür an dem Träger ein separater Anschluss in Form eines Steckers oder einer Buchse bereitgestellt werden muss.

Nachfolgend wird die Erfindung anhand der Zeichnungen näher erläutert. Dabei zeigen:
Fig. 1 bis Fig. 6 den jeweiligen Zustand des Trägers nach Durchführung von Verfahrensschritten zur Herstellung von Kontaktstellen, wobei der Träger in Schnittansicht dargestellt ist;
Fig. 7 zeigt einen Ausschnitt einer Draufsicht einer Leiterkarte; und
Fig. 8 zeigt eine schematische Ansicht eines Inline-Fertigungsprozesses zur Herstellung von Kontaktstellen im Rahmen des erfindungsgemäßen Herstellungsverfahrens.

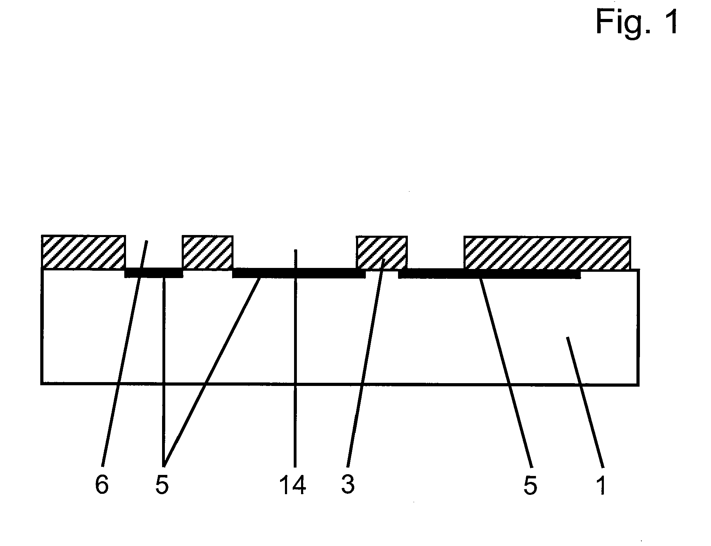

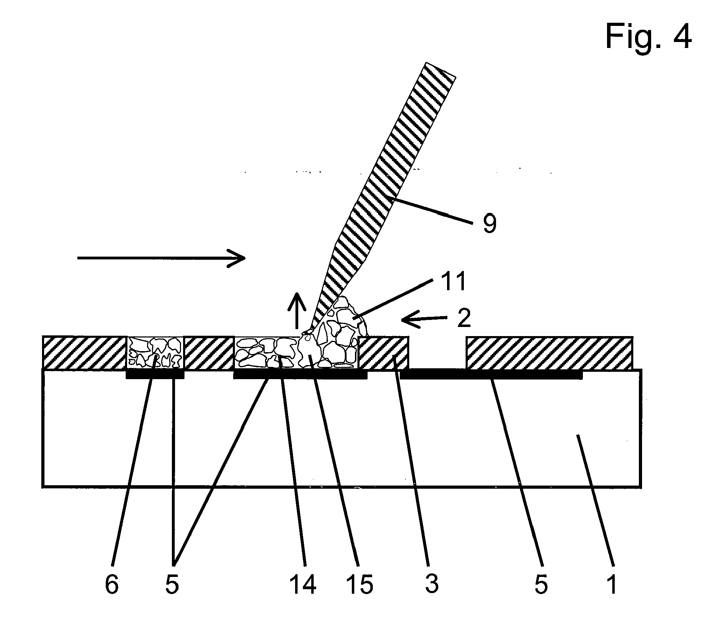

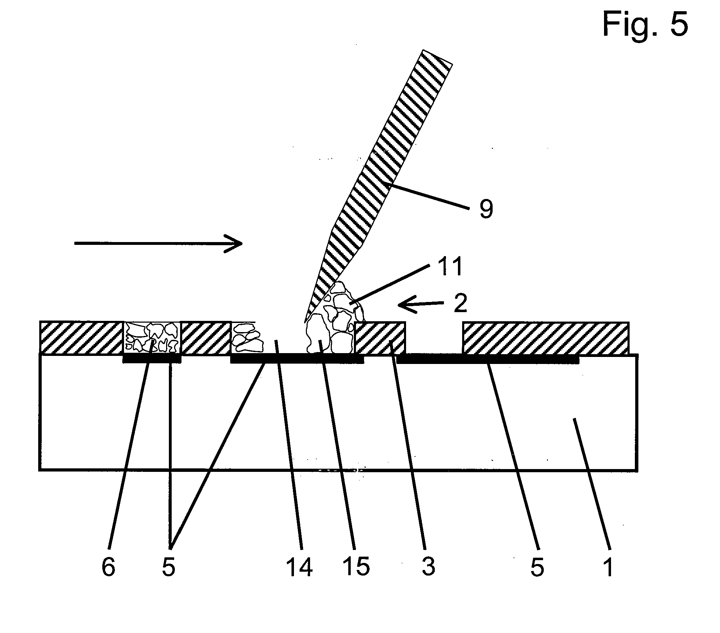

Fig. 1 bis Fig. 6 zeigen aufeinanderfolgende Verfahrensschritte zur Herstellung von Kontaktstellen auf Trägern. Dabei zeigen Fig. 1 bis Fig. 3 und Fig. 6 den zeitlichen Ablauf mit optimalen Prozessparametern, während Fig. 4 und Fig. 5 die Auswirkungen eines Abweichens von den optimalen Prozessparametern zeigen.

Fig. 1 zeigt in Schnittansicht einem Träger 1, welcher als eine Leiterkarte ausgebildet ist, nach einem ersten Verfahrensschritt zur Herstellung von Kontaktstellen. Der Träger 1 besteht in einer bevorzugten Ausführungsform aus einem mit Epoxidharz getränkten Glasfasergewebe. Der Träger 1 weist auf seiner Oberseite ein Netz aus Leiterbahnen 5 auf. Die Herstellung der Leiterbahnen 5 erfolgt in der Regel fotolithografisch, indem eine dünne Schicht lichtempfindlichen Fotolacks auf die Oberfläche des noch vollständig metallisierten Trägers aufgebracht wird. Nach der Belichtung des Fotolacks durch eine Maske mit dem gewünschten Platinenlayout werden entweder je nach Fotolack die belichteten oder die unbelichteten Anteile des Fotolacks in einer Entwicklerlösung entfernt. In einem anschließenden Ätzprozess werden die freigelegten Teile der metallisierten Oberfläche des Trägers 1 angegriffen und aufgelöst. Die mit Fotolack bedeckten Anteile bleiben erhalten, wobei diese die Leiterbahnen 5 ergeben.

Die Leiterbahnen 5 weisen üblicherweise Kupfer auf, welches korrodiert und daher nur für kurze Zeit lötbar ist. Um die Lagerfähigkeit des Trägers 1 und der Leiterbahnen 5 zu erhöhen, werden die Leiterbahnen mit einer Nickelschicht versehen. Da die Nickelschicht sich nach kurzer Zeit deaktiviert und damit keine Verbindung mit den zinnhaltigen Kontaktstellen eingeht, wird die Nickelschicht durch eine Goldschicht geschützt. Die Goldschicht geht beim Lötprozess in die Zinnschicht in Lösung, sodass das Nickel als Bindeglied zwischen der zinnhaltigen Kontaktierung und dem Kupfer dient.

Zur Herstellung von Kontaktstellen auf der Leiterkarte 5 des Trägers 1 wird eine Schablone 3 auf den Träger 1 angeordnet. Um zwei verschiedene Ausführungen von Kontaktstellen auf der Oberseite des Trägers 1 herzustellen, weist die auf der Oberfläche des Trägers 1 aufliegende Schablone 3, wie Fig. 1 zeigt, eine Mehrzahl von Öffnungen 6, 14 auf. Die Öffnungen 6, 14 dienen dabei zur Aufnahme einer Leitpaste und sind oberhalb der Leiterbahnen 5 an den gewünschten Kontaktstellen angebracht. In einer bevorzugten Ausführungsform weist die Schablone 3 eine Dicke von ca. 30 µm auf. Die Schablone kann jedoch auch andere Dicken aufweisen. Die Dicke der Schablone 3 orientiert sich an der zu erstellenden Kontaktstelle. Die Kontaktstellen des Trägers 1 werden in montiertem Zustand von Federelementen in einer Buchse kontaktiert und dienen als Steckerersatz. Dadurch wird dem Träger 1 und den Kontaktstellen ein Toleranzfenster durch die Bauform der Buchse vorgegeben. Das Toleranzfenster ist in einer Ausführungsform auf eine Dicke von 1,1 mm und einer Toleranz von ±0,1 mm festgelegt, wobei das Toleranzfenster sowohl von Bereichen des Trägers 1 ohne Kontaktstellen als auch in Bereichen des Trägers 1 mit Kontaktstellen einzuhalten ist. Auf diese Weise kann sowohl ein sicherer Halt des Trägers in der Buchse zu gewährleistet als auch um ein Überdehnen der Federelemente vermieden werden. Des Weiteren ist neben dem Toleranzfenster der Federelemente vorgegeben, dass die Schichtdicke der Kontaktstellen wenigstens 3 µm umfasst.

Die Öffnungen 6, 14 werden vorzugsweise mittels eines Lasers in die aus Edelstahl gefertigte Schablone 3 geschnitten. Die Schablone 3 kann aber auch aus einem hochfesten Kunststoff oder auch einer anderen Metallverbindung gefertigt werden. Die Schablone 3 ist vorzugsweise in einem Wechselrahmen fest in einem Rahmen eingebaut, da die Schablone bei einem Wechsel auf Grund ihrer geringen Dicke zum Einreißen neigt. Ferner kann auf diese Weise das Verletzungsrisiko des Monteurs beim Wechsel der Schablone reduziert werden.

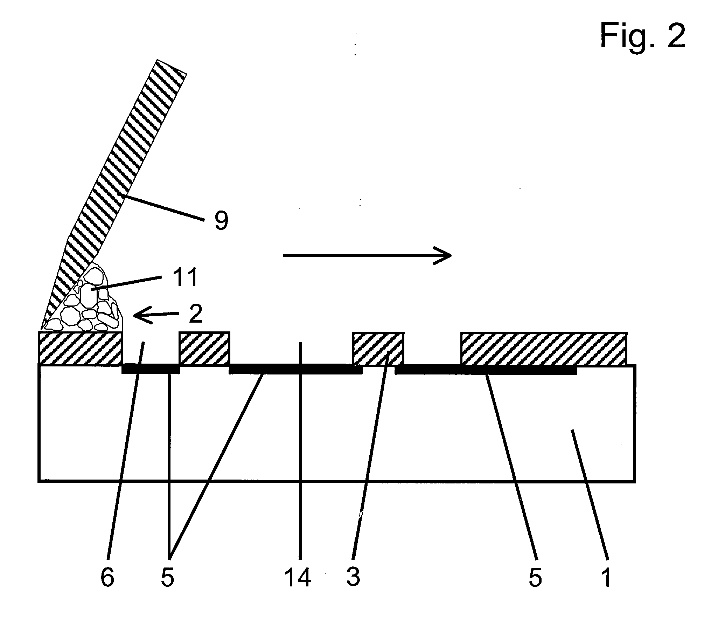

Fig. 2 zeigt den Träger 1 in Schnittansicht, auf welchem in einem zweiten Verfahrensschritt mit Hilfe eines Rakels 9 eine Leitpaste 2 in die Öffnungen 6, 14 gedrückt wird. Hierzu wird das Rakel 9 auf die Oberseite der Schablone 3 aufgesetzt. Das Rakel 9 ist in einem Winkel von ca. 45 bis 60° zur Oberfläche der Schablone 3 schräg liegend oberhalb der Schablone 3 und des Trägers 1 angeordnet, wobei das Rakel 9 in einer Bewegung von links nach rechts über die Oberfläche der Schablone 3 gleitet. Das Rakel 9 ist plattenförmig ausgeführt, wobei an der aufliegenden Seite des Rakels 9 die Flächen keilförmig aufeinander zulaufen. Dadurch ist das Ende des Rakels messerartig ausgebildet und liegt mit seiner Endkante an der Oberfläche der Schablone 3 auf.

In dem Bereich der Schablone 3 und vor dem Rakel 9 wird die Leitpaste 2 eingebracht, welche Körner 11 aufweist, deren Durchmesser überwiegend, im Bereich von 15 bis 40 µm liegt. Die Leitpaste 2 weist ein Flussmittel auf, welches als Zusatzstoff den Schmelzvorgang und die Handhabung der geschmolzenen Stoffe erleichtert. Dabei reduziert das Flussmittel die Oberflächenspannung des flüssigen Lotes und entoxidiert bei Erwärmung die Oberflächen der Fügepartner und des Lotes. Des Weiteren verhindert das Flussmittel die erneute Oxidbildung vor und während des Lötvorgangs durch die Bildung einer flüssigen Schutzschicht auf der Oberfläche des Trägers. Ohne die Verwendung eines Flussmittels wären die Fließ- und Benetzungseigenschaften des Lotes stark beeinträchtigt.

Als leitende Werkstoffe der Leitpaste 2 werden bei bleifreien Lötverbindungen insbesondere Zinn, Silber und/oder Kupfer angewandt. Gemäß einer Ausführungsform der Erfindung wird eine Leitpaste 2 verwendet, welche unter dem Namen "SAC305" bekannt ist. Die Körner der Leitpaste 2 weisen eine Zusammensetzung von 96,5 % Zinn, 3,0 % Silber und 0,5 % Kupfer auf.

Die Leitpaste 2 setzt sich zu etwa 90 % aus den Körnern 11 und aus dem Flussmittel zu 10 % zusammen.

In der Bewegung des Rakels 9 von links nach rechts wird die Leitpaste 2 mit den Körnern 11 über die Oberfläche der Schablone 3 geschoben und in die Öffnungen 6, 14 gedrückt. Des Weiteren sind die Einstellparameter für die Geschwindigkeit und den Druck des Rakels 9 so gewählt, dass möglichst wenig Leitpaste 2 unter dem Rakel 9 an seinem Ende und an der Oberfläche der Schablone 3 hindurch gleitet.

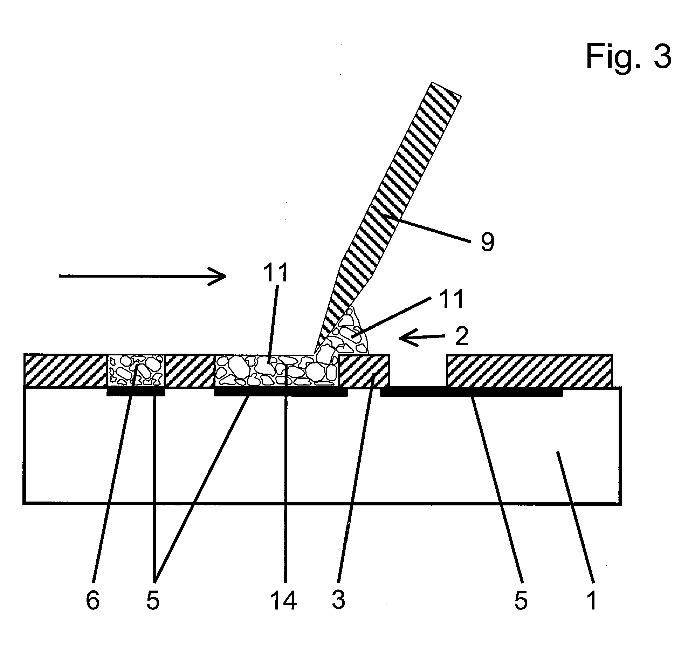

Fig. 3 zeigt eine Schnittansicht des Trägers 1 ausgehend von dem in Fig. 2 dargestellten Zustands, wobei das Rakel 9 in seiner Bewegung entlang der Oberfläche der Schablone 3 weiter nach rechts fortgeschritten ist. Eine erste Öffnung 6, welche linksseitig auf der Schablone 3 angeordnet ist, ist bereits mit Material der Leitpaste 2 verfüllt. Das Rakel 9 befindet sich über einer mittleren zweiten Öffnung 14 der Schablone 3 und verfüllt die mittlere zweite Öffnung 14 mit Material der Leitpaste 2.

Die Leitpaste 2 weist Körner 11 auf, die einen kleineren oder gleichen Durchmesser verglichen mit der Dicke der Schablone 3 aufweisen. Die Körnung entspricht beispielsweise einer Körnungsklasse 5, bei der die Größe der Körner 11 überwiegend, insbesondere wenigstens zu 80 Prozent im Bereich von 12 bis 30 µm liegt. Zwischen den einzelnen Körnern 14 ist ein Flussmittel eingebracht. Insbesondere eignet sich als Flussmittel FLUX 798LF der Firma Qualitek. Das Flussmittel dient im unverschmolzenen Zustand der Leitpaste als eine Art Kleber, der die einzelnen Körner 11 zusammenhält. Das Flussmittel ist zumindest teilweise auf wasserlöslicher Basis hergestellt, um eine an den Lötprozess anschließende Reinigung ausschließlich mit Wasser ohne Zusatz von Reinigungsmittel durchzuführen.

Beim Auftragens der Leitpaste 2 wirkt eine Kraft von bis zu 80 N auf das ca. 250 mm breite Rakel 9. Das Rakel 9 hat eine Verfahrgeschwindigkeit von ca. 20 bis 40 mm/s parallel zur Oberfläche der Schablone 3.

Fig. 4 zeigt den gleichen Verfahrensschritt wie Fig. 3, wobei die Prozessparameter wie Druck auf das Rakel 9 und dessen Verfahrgeschwindigkeit entsprechend der in Fig. 3 angegebenen Werte gewählt ist. Abweichend von Fig. 3 weist die Leitpaste 2 eine gröbere Körnungsklasse 4 auf, bei der die Größe der Körner 11 überwiegend, insbesondere wenigstens zu 80 Prozent im Bereich von 20 bis 40 µm liegt. Das Verhältnis der Schablone 3 im Bereich der Öffnungen 6, 14 zu dem durchschnittlichen maximalen Durchmesser der Körner 11 der Leitpaste 2, beträgt somit 0,75. Deshalb weist die Leitpaste 2 in der zweiten Öffnung 14 ein Korn 15 auf, dessen Durchmesser größer ist als die Dicke der Schablone 3, wobei deshalb Teile des Korns 15 aus der glattgestrichenen Oberfläche der Leitpaste 2 und der Schablone 3 herausragen. Durch eine elastische Verformung der Spitze des Rakels 9 an seiner aufliegenden Kante gleitet das Rakel 9 über das herausragende Korn 15. Dabei schwingt die aufliegende Kante des Rakels 9 nach oben. Diese elastische Verformung des Rakels 9 wird von den Prozessparametern Kraft auf das Rakel 9 und Verfahrgeschwindigkeit des Rakels 9 bestimmt.

Fig. 5 zeigt den gleichen Verfahrensschritt wie Fig. 4. Als Leitpaste ist die aus Fig. 4 bekannte Leitpaste verwendet. Allerdings sind die Prozessparameter außerhalb der in Fig. 3 und 4 und eingesetzten Werte gewählt. Die Darstellung zeigt die Wirkung einer Veränderung der Prozessparameter außerhalb der in Zusammenhang mit Fig. 3 und 4 angegebenen Bereiche. Dabei verklemmt sich das Korn 15 zwischen der Unterseite der zweiten Öffnung 14 und dem Rakel 9. Durch eine zu hohe Vorschubgeschwindigkeit des Rakels 9 schwingt das Rakel 9 nicht wie in Fig. 4 in einer elastischen Verformung nach oben, sodass der Endbereich des Rakels 9 nicht über das Korn 15 hinweg gleitet. Dadurch verklemmt sich das Korn 15 zwischen der Unterseite der zweiten Öffnung 14 und dem Endbereich des Rakels 9 und wird durch den Vorschub des Rakels 9 durch die Öffnung 14 geschoben. Dabei räumt das Korn 15 Teile des bereits in die zweite Öffnung 14 eingepressten Materials der Leitpaste 2 aus. Das Rakel 9 gleitet erst über das Korn 15, wenn das Korn 15 an der rechtseitigen Seitenfläche der zweiten Öffnung 14 anliegt. Dies kann auch zu einer dauerhaften Zerstörung der Endkante des Rakels 9 führen.

Gleiche Effekte wie sie in Fig. 5 gezeigt sind, können auftreten, wenn die Kraft auf das Rakel 9 zu groß gewählt ist oder wenn sowohl die Kraft auf das Rakel 9 und auch die Verfahrgeschwindigkeit des Rakels 9 außerhalb der in Zusammenhang mit Fig.3 angegebenen Bereiche liegt. Auch eine korrekt eingestellte Kraft auf das Rakel 9 kann in Verbindung mit einer zu hoch eingestellten Vorschubgeschwindigkeit des Rakels 9 zu einem Ausräumen der Öffnungen 6, 14 führen.

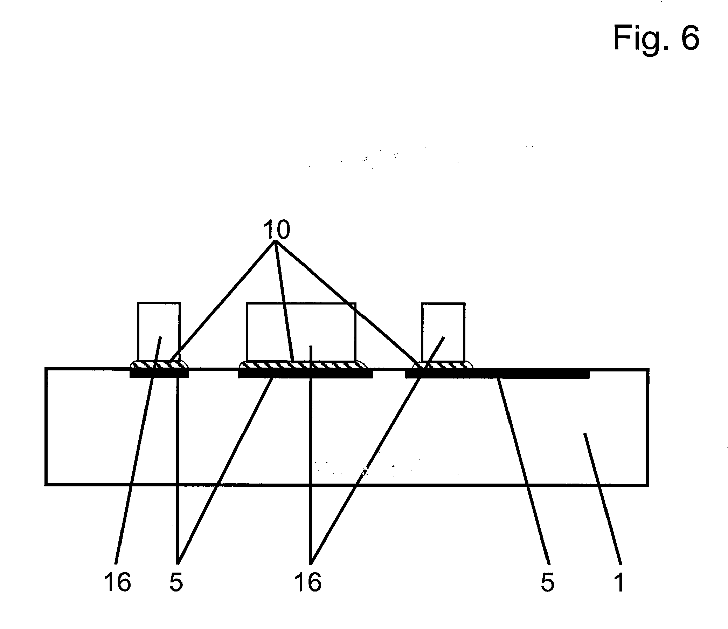

Fig. 6 zeigt eine Schnittansicht des Trägers 1 nach dem Aufbringen der Leitpaste 2 auf die Kontaktstellen 10 der Leiterbahnen 5. Nach dem Entfernen der Schablone 3 von der Oberfläche des Trägers 1, wird die sich in den Öffnungen 6, 14 der Schablone 5 befindenden Leitpaste 2 aufgeschmolzen. Dabei verschmelzen die Körner 11 der Leitpaste 2 zu einzelnen Kontaktstellen 10, wobei sich das Volumen der Kontaktstellen gegenüber dem Volumen der Öffnungen 6, 14 in der Schablone 5 dadurch reduziert, dass das Flussmittels aus dem Körnerverband der Leitpaste 2 während des Aufschmelzens gelöst wird, sowie dadurch, dass Zinnatome in die Leiterbahnen 5 eindiffundieren. Die Diffusion wird durch eine Nickel-Gold-Beschichtung der Leiterbahnen 5 reduziert, aber auf Grund der Dicke der Beschichtung nicht verhindert. Die Oberfläche der Kontaktstellen 10 ist ballenartig, schichtartig ausgebildet.

Auf den Kontaktstellen 10 können Federelemente 16 angebracht werden, welche den Kontakt zwischen dem Träger 1 und einem weiterem Träger herstellen. Durch die gemäß dem vorstehenden Verfahren erstellte ballenartige Oberflächenform der Kontaktstellen 10 können die Federelemente 16 beim Auf- und Abstecken ohne Verhaken entlang gleiten. Durch die Möglichkeit die größere Schichtdicke den Kontaktstellen 10 im Bereich von wenigstens 3 µm zu erzeugen, weisen die Kontaktstellen 10 Verschleißreserven hinsichtlich des Auf- und Absteckens der Federelemente 16 auf. Wenn die Schablone wie vorstehend erläutert eine Dicke von 30 µm im Bereich der Öffnungen aufweist, bildet sich nach dem Aufschmelzen eine maximale Schichtdicke der Kontaktstellen 10 von ca. 45 bis 50 µm aus, wobei durch die ballenartige Ausbildung der Kontaktstelle die Schichtdicke an den Rändern der Kontaktstelle geringer ist. Dadurch kann das vorgegebene Toleranzfenster für die Kontaktstellen zusammen mit dem Träger 1 eingehalten werden.

Dem Fachmann ist selbstverständlich geläufig, dass die Prozessparameter wie etwa die Kraft auf das Rakel oder dessen Verfahrgeschwindigkeit beispielhaft sind. Wesentlich ist jedoch, dass die Schablone zur Herstellung von Kontaktstellen eine Schichtdicke von wenigstens 3 µm im Bereich der Öffnungen aufweist und dass dabei das Verhältnis der Dicke der Schablone im Bereich der Öffnungen zu der durchschnittlichen maximalen Korngröße der Leitpaste nicht größer ist als 1,5. Dadurch können Kontaktstellen auf einem Träger 1 erstellt werden, die die Toleranzfenster für eine Steckverbindung einhalten.

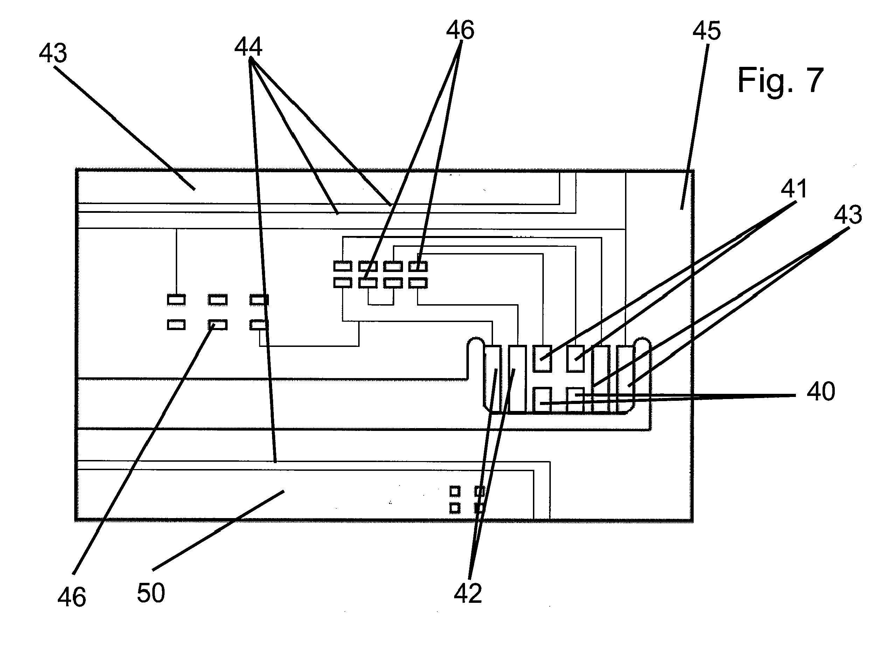

Fig. 7 zeigt einen Ausschnitt einer Draufsicht einer Leiterkarte 49, deren Kontaktstellen 40 bis 43 mit dem anhand Fig. 1 bis Fig. 6 beschriebenen Herstellungsverfahren erstellt wurden. Die Darstellung zeigt einen Gesamtträger, welcher verschiedene plattenförmige Leiterkarten 49 aufnimmt. Die Leiterkarten 49 werden nach dem Herstellungsprozess und nach dem Bestückungsprozess mit SMD-Bausteinen von dem Gesamtträger 45 z. B. durch Ausfräsen getrennt. Dies hat den Vorteil, dass durch das Zusammenfassen von mehreren Leiterkarten 49 zu einem Gesamtträger 45 mehrere Leiterkarten 49 in einem Herstellungsschritt bearbeitet werden können.

Die Leiterkarte 49 weist einen Steckbereich mit den verschiedenen Kontaktstellen 40 bis 43 auf, welcher aus der Leiterkarte 49 seitlich ragt. Der Steckbereich dient dazu die Leiterkarte 49 mittels einer nicht dargestellten Buchse an einer weiteren Baugruppe anzuschließen. Die Buchse verbindet die weitere Baugruppe mittels Federkontakte, welche auf den Kontaktstellen 40 bis 43 in montiertem Zustand aufliegen. Das Toleranzfenster der Kontaktstellen 40 bis 43 entspricht dem Toleranzfenser der in Fig. 1 bis 6 beschriebenen Kontaktstellen 10. Der Steckbereich ist linksseitig durch eine längliche Ausnehmung begrenzt, in die das Gehäuse der Buchse in montiertem Zustand greift. Der Steckbereich weist an seinen beiden Seiten jeweils zwei längliche erste Kontaktstellen 42, 43 auf. Zwischen den ersten Kontaktstellen 42, 43 sind je zwei quaderförmig ausgebildete zweite Kontaktstellen 41 angeordnet. Unterhalb dieser Kontaktstellen sind ebenfalls zwei je quaderförmig ausgebildete dritte Kontaktstellen 40 angeordnet, welche auf der Rückseite der Leiterkarte 49 mittels Leiterbahnen, welche nicht dargestellt sind, kontaktiert sind. Die ersten und zweiten Kontaktstellen 42, 43, 41 sind auf der Oberseite der Leiterkarte 49 mittels Leiterbahnen 44 mit weiteren Kontaktstellen 46, die zur Kontaktierung von SMD-Bausteinen dienen, verbunden. Mit dem in Fig. 1 bis Fig. 6 beschriebenen Herstellungsverfahren werden jedoch nur die ersten, zweiten und dritten Kontaktstellen 40 bis 43 des Steckbereiches mit einer zinnhaltigen Schicht im Bereich von wenigstens 3 µm versehen.

Die weiteren Kontaktstellen 46 können mit anderen bekannten Schablonendruckverfahren kontaktiert. Die weiteren Kontaktstellen 46 dienen zur Anbindung von weiteren Bauteilen z.B. SMD-Bauteilen und sind daher mit einer dickeren zinnhaltigen Schicht z.B. 125 µm zu versehen, um die Bauteile sowohl zu kontaktieren als auch zu befestigen. Zum Aufbringen dieser Schichtdicken werden üblicherweise ähnliche Körnungsklassen von Leitpasten verwendet wie in dem erfindungsgemäßen Verfahren. Dadurch liegt bei den herkömmlichen Schablonendruckverfahren ein Verhältnis von etwas 3 bei einer Dicke der Schablone an den Öffnungen von 125 µm und einer üblichen Körnung von 15 bis 40 µm mit einem durchschnittlichen maximalen Körungsdurchmesser von 40 µm vor. Diese Schichtdicken eignen sich nicht für Kontaktstellen auf einer Leiterkarte 49 mit dem in der Ausführungsform vorgegebenen Toleranzfenster.

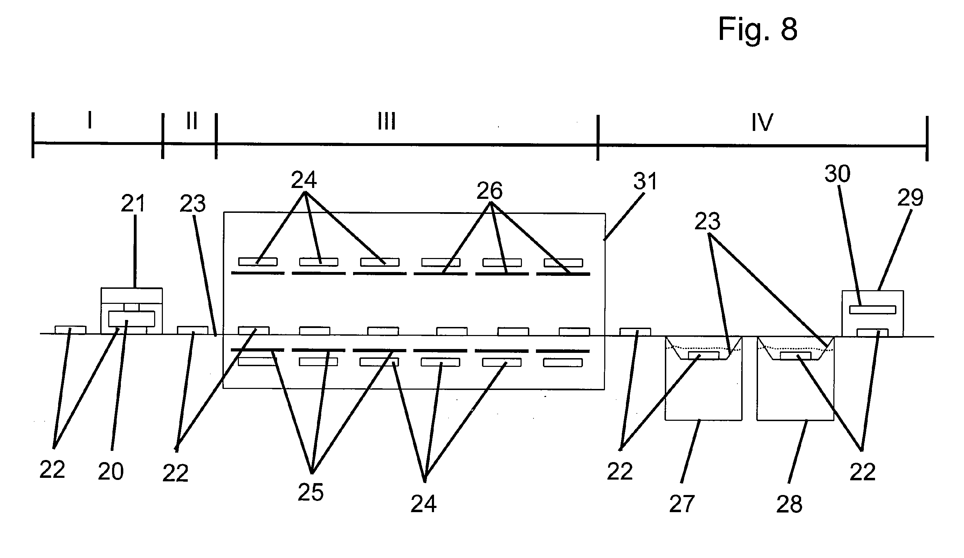

Fig. 8 zeigt eine schematische Darstellung einer Inline-Fertigungsanlage zur Herstellung von zinnhaltigen Kontaktstellen im Bereich von wenigstens 3 µm an Leiterkarten 22. Das Herstellungsverfahren weist vier Abschnitte auf. Die Abschnitte sind mit römischen Buchstaben in der Darstellung gekennzeichnet. Die einzelnen Abschnitte umfassen dabei: Aufbringen der Leitpaste auf den Träger (Abschnitt I), Sichtprüfung (Abschnitt II), Reflow-Löten (Abschnitt III)und Reinigen (Abschnitt IV). Dabei sind die einzelnen Abschnitte mittels eines Transportbandes 23 z.B. mit einem Edelstahl-Gitterband verbunden. Um eine Leiterkarte 22 mit dem vorstehend dargestellten Herstellungsverfahren mit einer zinnhaltigen Schicht im Bereich von wenigstens 3 µm an den Kontaktstellen der Leiterkarte 22 zu versehen, werden die Leiterkarten vor dem Abschnitt I auf das Transportband 23 gebracht. Dies kann manuell durch den Bediener oder auch maschinell erfolgen.

Die Leiterkarte 22 wird im Abschnitt I durch das Transportband 23 in den Leitpastendrucker 21 verbracht, wo sie mittels eines Rakels 20 und einer nicht dargestellten Schablone mit Leitpaste versehen werden. Der Vorgang und die Prozessparameter wie etwa die Kraft auf das Rakel 20 und dessen Vorschubgeschwindigkeit entsprechen dem anhand Fig. 3 und 4 erläuterten Verfahren. Die Körner der Leitpaste weisen einen maximalen durchschnittlichen Durchmesser auf, welcher nicht größer ist als das 1,5-fache der Dicke der Schablone an ihren Öffnungen. Die nicht dargestellte Schablone weist vorzugsweise eine Dicke von ca. 30 µm auf.

Das Ergebnis des Aufbringens der Leitpaste wird durch eine Sichtkontrolle in Abschnitt II durch den Bediener kontrolliert, wobei die Leiterkarte 22 mittels des Transportbandes 23 kontinuierlich aus dem Leitpastendrucker 21 weiterbefördert wird.

Im weiteren Verlauf wird die Leiterkarte 22 im Abschnitt III in einen Reflow-Ofen 31 transportiert. Der Reflow-Ofen 31 weist neben dem Transportband 23, welches hitzefest hinsichtlich der Temperaturen im Reflow-Ofen 31 ist, oberhalb und unterhalb des Transportbandes angebrachte Heizelemente 25, 26 auf. Die Heizelemente 25, 26 können so angesteuert werden, dass unterschiedliche Temperaturzonen innerhalb des Reflow-Ofens 31 ermöglicht werden. Um eine günstige Verteilung der Hitze in dem Reflow-Ofen 31 zu gewährleisten, sind oberhalb der oberen Heizelemente 26 für jeweils ein oberes Heizelement 26 ein Gebläse 24 vorgesehen. Entsprechend ist unterhalb unter den unteren Heizelementen 25 jeweils ein Gebläse 24 angebracht.

Optional verfügt der Reflow-Ofen 31 auch über einen nicht dargestellten Inertgasanschluss. Durch die gezielte Steuerung des Inertgases können die Flusseigenschaften des Lotes im aufgeschmolzenen Zustand beeinflusst werden. Beispielsweise kann durch die Zugabe von Stickstoff das Flussverhalten der Lote gezielt verbessert werden. Es können jedoch die Prozessparameter und das Flussmittel so gewählt, dass auf die Zugabe von Inertgas verzichtet werden kann.

Bevor die Schmelztemperatur erreicht wird, wird für ca. 1,5 bis 2 Minuten die Leiterkarte 22 im Reflow-Ofen 31 erwärmt, wobei der Anstieg der Temperatur nicht größer als 2,5°C pro Sekunde betragen sollte. Im sogenannten Ziehbereich, welcher sich an den Vorwärmbereich anschließt, wird die Leiterkarte 22 von ca. 120°C auf bis zu 160°C erwärmt. Dabei findet die Erwärmung deutlich langsamer statt als im Vorwärmbereich. Im Anschluss an diesen Bereich befindet sich der Reflow-Bereich, bei dem die Leitpaste aufgeschmolzen wird. Die Temperaturen im Reflow-Bereich betragen ca. 250 bis 300°C. Die Temperaturen liegen dabei deutlich über dem Schmelzpunkt der Leitpaste von ca. 217°C. Die Schmelztemperatur ist abhängig von der Legierung der Leitpaste. In einer Ausführungsform wird die Legierung "SAC305" verwendet, es sind jedoch auch andere Leitpasten hierfür möglich.

Nach dem Aufschmelzen kühlt die Leiterkarte 22 ab. Dieses Abkühlen kann auch außerhalb des Reflow-Ofens 31 stattfinden. Anstelle eines Reflow-Ofens 31 für den Vollkonvektions-Reflow-Lötprozesses können auch Öfen eingesetzt werden, die mittels eines Kondensations-Lötprozess oder einem Infrarot-Lötprozesses die Leitpaste aufschmelzen.

Nach dem Aufschmelzen der Leitpaste im Reflow-Ofen 31 des Abschnitts III sind die Rückstände des Flussmittels der Leitpaste von den Leiterkarten 22 zu entfernen. Die Reinigung wird in Abschnitt IV durchgeführt. Das in einer Ausführungsform verwendete Flussmittel weist korrosive Eigenschaften auf und gehört zur Kategorie "Clean-Paste". Diese Pasten unterscheiden sich von den "No-Clean-Pasten" dadurch, dass sie Säuren oder andere korrosive Inhaltsstoffe z.B. Zinkchlorid aufweisen, die nach dem Aufschmelzen der Leitpaste zu entfernen sind, um eine dauerhafte Zerstörung der Leiterkarte 22 zu verhindern. Die "No-Clean-Pasten" müssen nicht nach dem Aufschmelzen gereinigt werden. Sie bilden jedoch einen krustenartigen Belag auf der Lötstelle aus, welcher zu entfernen ist, falls die Lötstelle mittels eines Federelements zu kontaktieren ist. Wird die Leitpaste durch das Flussmittel z.B. FLUX 798LF der Firma Qualitek den "Clean-Paste" zugeordnet, kann das Flussmittel nach dem Aufschmelzen mittels z. B. 60°C heißem deionisierten Wasser entfernt werden. Ein Zusatz von weiteren Reinigungsmitteln z.B. Laugen ist nicht notwendig.

Die Leiterkarte 22 wird auf dem Transportband 23 zuerst in ein Reinigungsbecken 27 transportiert, von wo die Leiterkarte 22 weiter in ein Spülbecken 28 transportiert wird. In dem Reinigungsbecken 27 wird mittels heißem Wasser, welches aus Düsen auf die Leiterkarte 22 gespritzt wird, die verbleibenden Reste des Flussmittels von der Leiterkarte 22 entfernt. Um die Leiterkarte 22 von dem Reinigungswasser und darin enthaltenen Resten zu säubern, wird die Leiterkarte 22 in dem Spülbecken 28 nochmals mit heißem Wasser gespült. In einem anschließenden Trocknungsschritt wird die Leiterkarte 22 in der Trocknungseinheit 29, welches ein Heizelement 30 aufweist, mit Warmluft getrocknet. Nach Verlassen der Reinigungseinheit von Abschnitt IV ist die Herstellung von zinnhaltigen Kontaktstellen im Bereich von wenigstens 3 µm abgeschlossen.

Das vorstehend beschriebene Verfahren zu Herstellung von Kontaktstellen eignet sich sowohl für bleifreie als auch für bleihaltige Lötverbindungen. Dabei zeigen bleihaltige Leitpasten verbesserte Flusseigenschaften gegenüber bleifreien Leitpasten. Ebenso sind auf Grund der niedrigeren Schmelztemperaturen der bleihaltigen Leitpasten die Prozesstemperaturen im Reflow-Ofen niedriger und damit schonender für die zu verlötenden Bausteine als bei bleifreien Leitpasten.

## Patentansprüche

1. Verfahren zum Herstellen von Kontaktstellen (10) aus einer Leitpaste (2) auf einem Träger (1), insbesondere einer Leiterkarte, wobei die Leitpaste (2) ein Flussmittel und zumindest einen leitenden Werkstoff aufweist, der als Körner (11) in der Leitpaste (2) enthalten ist, mit den folgenden Schritten:
- Anbringen einer Schablone (3) mit Öffnungen (6, 14), die die Kontaktstellen auf dem Träger (1) festlegen,
- Einbringen der Leitpaste (2) in die Öffnungen (6, 14) der Schablone (3), wobei mithilfe eines Rakels (9) die Leitpaste (2) auf der Schablone (3) verteilt und in die Öffnungen (6, 14) gedrückt wird und
- Aufschmelzen der Leitpaste (2), wobei eine verschmolzene Schicht auf dem Träger (1) ausgebildet wird,
**dadurch gekennzeichnet, dass** das Verhältnis der Dicke der Schablone (3) im Bereich der Öffnungen (6, 14) zu dem durchschnittlichen maximalen Durchmesser der Körner (11) der Leitpaste (2) nicht größer ist als 1,5 und dass die Schablone im Bereich der Öffnungen (6, 14) eine Dicke bis zu 50 Mikrometer aufweist.

2. Verfahren nach Anspruch 1, **dadurch gekennzeichnet, dass** die Schablone (3) eine Dicke von etwa 30 Mikrometer aufweist und dass die Leitpaste (2) Körner (11) aufweist, deren Durchmesser überwiegend, insbesondere wenigstens zu 80 Prozent, im Bereich von 15 bis 40 Mikrometer liegt.

3. Verfahren nach Anspruch 1, **dadurch gekennzeichnet, dass** die Dicke der Schablone (3) im Bereich der Öffnungen zu dem durchschnittlichen maximalen Durchmesser der Körner (11) der Leitpaste (2) etwa gleich ist.

4. Verfahren nach einem der Ansprüche 1 bis 3, **dadurch gekennzeichnet, dass** das Aufschmelzen der Körner (11) der Leitpaste (2) auf dem Träger (1) mithilfe eines Vollkonvektions-Reflow-Lötprozesses, eines Kondensations-Lötprozesses oder einem Infrarot-Lötprozesses erfolgt.

5. Verfahren nach einem der Ansprüche 1 bis 4, **dadurch gekennzeichnet, dass** der Träger (1) eine Isolierung und eine Leiterbahn (5) aufweist, wobei die Leiterbahn (5) des Trägers (1) zumindest teilweise Nickel und/oder Gold aufweist.

6. Verfahren nach einem der Ansprüche 1 bis 5, **dadurch gekennzeichnet, dass** eine Kraft von bis zu 80 N auf das Rakel (9) wirkt und das Rakel (9) gegenüber der Schablone (3) mit einer Geschwindigkeit von 20 bis 40 mm/s entlang der Schablonenoberfläche bewegt wird.

7. Verfahren nach einem der Ansprüche 1 bis 6, **dadurch gekennzeichnet, dass** einen leitenden Werkstoff der Leitpaste (2) insbesondere Zinn, Silber und/oder Kupfer umfasst.

8. Verfahren nach einem der Ansprüche 1 bis 7, **dadurch gekennzeichnet, dass** das Flussmittel der Leitpaste (2) zumindest teilweise auf wasserlöslicher Basis hergestellt ist.

9. Verfahren nach Anspruch 8, **dadurch gekennzeichnet, dass** der Träger (1) nach dem Aufschmelzen nass gereinigt wird.

10. Verfahren nach einem der Ansprüche 1 bis 9, **dadurch gekennzeichnet, dass** die Schablone (3) in einem Rahmen angeordnet ist, wobei die Schablone (3) plattenförmig ausgebildet ist und Öffnungen (6, 14) aufweist.

11. Verfahren nach einem der Ansprüche 1 bis 10, **dadurch gekennzeichnet, dass** die Kontaktstelle (10) des Trägers (1) mittels eines Federelements (16) zum Anschluss an eine Baugruppe kontaktiert wird.

12. Träger (1) aufweisend eine Isolierung, eine Leiterbahn (5) und wenigstens eine Kontaktstelle (10), **dadurch gekennzeichnet, dass** wenigstens eine Kontaktstelle (10) mit Hilfe des Verfahrens gemäß Anspruch 1 bis 11 hergestellt ist.

13. Träger (1) nach Anspruch 12, **dadurch gekennzeichnet, dass** der Träger im Bereich der Kontaktstellen (10) durch ein Federelement (16) kontaktierbar ist.

14. Träger (1) nach einem der Ansprüche 12 oder 13, **dadurch gekennzeichnet, dass** der Träger (1) im Bereich der Kontaktstellen (10) eine Steckverbindung ausbildet.

## Geänderte Patentansprüche

### Geänderte Patentansprüche gemäss Regel 137(2) EPÜ.

**1.** Verfahren zum Herstellen von Kontaktstellen (10) aus einer Leitpaste (2) auf einem Träger (1), insbesondere einer Leiterkarte, wobei die Leitpaste (2) ein Flussmittel und zumindest einen leitenden Werkstoff aufweist, der als Körner (11)in der Leitpaste (2) enthalten ist, mit den folgenden Schritten:
- Anbringen einer Schablone (3) mit Öffnungen (6, 14), die die Kontaktstellen auf dem Träger (1) festlegen,
- Einbringen der Leitpaste (2) in die Öffnungen (6, 14) der Schablone (3), wobei mithilfe eines Rakels (9) die Leitpaste (2) auf der Schablone (3) verteilt und in die Öffnungen (6, 14) gedrückt wird und
- Aufschmelzen der Leitpaste (2), wobei eine verschmolzene Schicht auf dem Träger (1) ausgebildet wird,
**dadurch gekennzeichnet, dass** das Verhältnis des maximalen Durchmesser von wenigstens 80 Prozent der Körner (11) der Leitpaste (2) bezüglich der Dicke der Schablone (3) im Bereich der Öffnungen (6, 14) nicht größer ist als 1,5, wobei die Schablone im Bereich der Öffnungen (6, 14) eine Dicke von bis zu 50 Mikrometer aufweist, und dass eine Kraft von bis zu 80 N auf das Rakel (9) wirkt, wobei das Rakel (9) gegenüber der Schablone (3) mit einer Geschwindigkeit von 20 bis 40 mm/s entlang der Schablonenoberfläche bewegt wird.

**2.** Verfahren nach Anspruch 1, **dadurch gekennzeichnet, dass** die Schablone (3) eine Dicke von etwa 30 Mikrometer aufweist und dass die Leitpaste (2) Körner (11) aufweist, deren Durchmesser überwiegend, insbesondere wenigstens zu 80 Prozent, im Bereich von 15 bis 40 Mikrometer liegt.

**3.** Verfahren nach Anspruch 1, **dadurch gekennzeichnet, dass** die Dicke der Schablone (3) im Bereich der Öffnungen zu dem maximalen Durchmesser der Körner (11) der Leitpaste (2) etwa gleich ist.

**4.** Verfahren nach einem der Ansprüche 1 bis 3, **dadurch gekennzeichnet, dass** das Aufschmelzen der Körner (11) der Leitpaste (2) auf dem Träger (1) mithilfe eines Vollkonvektions-Reflow-Lötprozesses, eines Kondensations-Lötprozesses oder einem Infrarot-Lötprozesses erfolgt.

**5.** Verfahren nach einem der Ansprüche 1 bis 4, **dadurch gekennzeichnet, dass** der Träger (1) eine Isolierung und eine Leiterbahn (5) aufweist, wobei die Leiterbahn (5) des Trägers (1) zumindest teilweise Nickel und/oder Gold aufweist.

**6.** Verfahren nach einem der Ansprüche 1 bis 5, **dadurch gekennzeichnet, dass** die Leitpaste einen bleifreien Werkstoffzusammensetzung aufweist.

**7.** Verfahren nach einem der Ansprüche 1 bis 6, **dadurch gekennzeichnet, dass** einen leitenden Werkstoff der Leitpaste (2) insbesondere Zinn, Silber und/oder Kupfer umfasst.

**8.** Verfahren nach einem der Ansprüche 1 bis 7, **dadurch gekennzeichnet, dass** das Flussmittel der Leitpaste (2) zumindest teilweise auf wasserlöslicher Basis hergestellt ist.

**9.** Verfahren nach Anspruch 8, **dadurch gekennzeichnet, dass** der Träger (1) nach dem Aufschmelzen nass gereinigt wird.

**10.** Verfahren nach einem der Ansprüche 1 bis 9, **dadurch gekennzeichnet, dass** die Schablone (3) in einem Rahmen angeordnet ist, wobei die Schablone (3) plattenförmig ausgebildet ist und Öffnungen (6, 14) aufweist.

**11.** Verfahren nach einem der Ansprüche 1 bis 10, **dadurch gekennzeichnet, dass** die Kontaktstelle (10) des Trägers (1) mittels eines Federelements (16) zum Anschluss an eine Baugruppe kontaktiert wird.

**12.** Träger (1) aufweisend eine Isolierung, eine Leiterbahn (5) und wenigstens eine Kontaktstelle (10), **dadurch gekennzeichnet, dass** wenigstens eine Kontaktstelle (10) mit Hilfe des Verfahrens gemäß Anspruch 1 bis 11 hergestellt ist.

**13.** Träger (1) nach Anspruch 12, **dadurch gekennzeichnet, dass** der Träger im Bereich der Kontaktstellen (10) durch ein Federelement (16) kontaktierbar ist.

**14.** Träger (1) nach einem der Ansprüche 12 oder 13, **dadurch gekennzeichnet, dass** der Träger (1) im Bereich der Kontaktstellen (10) eine Steckverbindung ausbildet.
